(19) Europäisches Patentamt
European Patent Office
Office européen des brevets

(11) Publication number: **0 548 368 A1**

(12) **EUROPEAN PATENT APPLICATION published in accordance with Art. 158(3) EPC**

(21) Application number: **92914380.8**

(22) Date of filing: **06.07.92**

(86) International application number: **PCT/JP92/00850**

(87) International publication number: **WO 93/01614 (21.01.93 93/03)**

(51) Int. Cl.[5]: **H01L 21/205**

(30) Priority: **05.07.91 JP 190883/91**

(43) Date of publication of application: **30.06.93 Bulletin 93/26**

(84) Designated Contracting States: **DE FR GB**

(71) Applicant: **MITSUBISHI KASEI CORPORATION**
**5-2, Marunouchi 2-chome Chiyoda-ku**
**Tokyo 100(JP)**

(72) Inventor: **SHIMOYAMA, Kenji, Mitsubishi Kasei Corporation**
**Sogo Kenkyusho 1000, Higashi Mamiana-cho**
**Ushiku-shi Ibaraki 300-12(JP)**
Inventor: **GOTOH, Hideki, Mitsubishi Kasei Corporation**
**Sogo Kenkyusho 1000, Higashi Mamiana-cho**
**Ushiku-shi Ibaraki 300-12(JP)**

(74) Representative: **Vossius & Partner**
**Siebertstrasse 4 P.O. Box 86 07 67**
**W-8000 München 80 (DE)**

(54) **COMPOUND SEMICONDUCTOR AND MANUFACTURING METHOD THEREFOR.**

(57) In a method of epitaxially growing a III-V compound semiconductor thin film, using a hydride and an organic metal both containing no halogens as the material for the epitaxial growth, a small amount of a halide gas and/or a halogen gas both containing no elements constituting the compound to be grown is added to the material gas in the course of the vapor growth. By the addition the hetero-interface can be flattened, and a high quality crystal can be grown over a wide range without depositing polycrystals on the mask.

FIG. 7

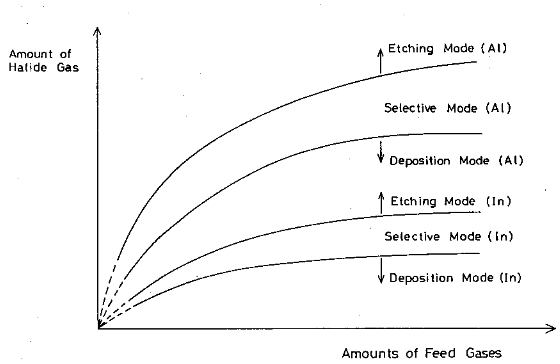


EP 0 548 368 A1

## TECHNICAL FIELD

The present invention relates generally to a process for forming a compound semiconductor layer by the vapor phase growth of a thin film form of compound semiconductor starting from a hydride and an organic metal, and more particularly to a process for the fabrication of a compound semiconductor that lends itself well fit both for the flattening of the grown layer and for inhibiting deposition of polycrystals on a protective film for selective growth.

## BACKGROUND TECHNIQUE

In order to improve the performance of compound semiconductor elements, quantum-effect devices and devices making use of two dimensional electron gases are now under vigorous development. For the fabrication of these devices, it is required to place growth rates under precise control, and this is usually achieved by using molecular beam epitaxial (MBE) and metal organic vapor phase epitaxial (MOVPE) growth techniques. Indeed, these epitaxial growth techniques are used to form heterojunction interfaces that are sharp at an atomic layer level. When these structures are applied to elements, the element properties are largely affected by the flatness of the heterojunction interfaces. For instance, an Al-containing compound interface is unsatisfactory in terms of flatness, because the migration length of the Al-containing compound molecules is short, offering some problems such as an electron mobility drop. In recent years, selective growth has been used to achieve an optimal device structure. However, since much difficulty is involved in achieving the selective growth by the MBE technique, the MOVPE technique is usually employed to this end. The selective growth process has a great advantage that a selective growth region of high quality and hence a high-performance element can be obtained, partly because it causes no damage to material and partly because it takes place at a relative low temperature.

However, the selective growth process is subject to some considerable restriction in terms of growth conditions, mole fraction , mask width, etc., for inhibiting deposition polycrystal on a protective film.

Especially in the case of an Al-containing compound, the higher the compositionof Al and the larger the mask width, the more likely is the deposition of polycrystals on the protective film. This offers a problem that any desired device structure is unachievable.

An object of the present invention is to provide a process for the fabrication of a semiconductor having the heterojunction interface improved in terms of flatness and providing device with excellent properties.

## DISCLOSURE OF THE INVENTION

The inventors have made intensive and far-reaching investigations so as to provide a solution to the problems mentioned above, and have consequently accomplished the present invention on the basis of the finding that when forming the heterostructure of a compound semiconductor or attaining the selective growth of crystals, a halide gas and/or a halogen gas free from the mother elements of the compound to be grown is added to the reaction atmosphere, thereby making it possible to flatten the surface of the grown layer or attain the growth of high-quality crystals without deposition of polycrystals on a mask over a wide region. More specifically, the present invention provides a vapor phase growth process for fabricating a thin film of compound semiconductor by the use of a halogen element-free hydride and a halogen element-free organic metal as the source materials, said process being characterized in that a halide gas and/or a halogen gas that are free from the mother elements of the compound to be grown are added to the reaction atmosphere during the growth.

For the source materials for compound semiconductors used in the fabrication process of the invention, any desired materials may be used, with the proviso that they are ordinarily used hydrides and organic metals, all being free from halogen elements. In the invention, the halogen element-free hydrides used are generally arsine ($AsH_3$), phosphine ($PH_3$), and so on, and the halogen element-free organic metals used are generally trimethylgallium (TMG), triethylgallium (TEG), trimethylaluminum (TMA), trimethylindium (TMI), and so on.

In the invention, the halogen element-free source materials are used, as mentioned above, and this is because the use of halogenides of Group III or V such as gallium chloride (GaCl), diethylgallium chloride (DEGaCl), and arsenic trichloride ($AsCl_3$) makes growth mechanism complicated, renders precise growth rate control difficult, causes a quartz tube to be subject to a corrosive attack in the case of the growth of Al-containing compounds, or offers other problems.

For the halide gas and/or halogen gas that are free from the mother elements of the compound to be grown, by way of example but not by way of limitation, use may be made of HBr, HI, HF, HCl, and $CCl_2F_2$ -

(for the halide gas) and $Cl_2$, $I_2$, $F_2$, and $Br_2$ or their mixtures (for the halogen gas). Notice that preference is given to HCl.

The quantity of the halide gas and/or halogen gas used, that are free from the mother elements of the compound to be grown, may vary largely depending on growth chamber size, growth temperature, etc., and may usually be smaller than the quantities of the halogen element-free organic metal.

The quantitative relation between both the gases is then determined such that a selective mode wherein crystal growth takes place but no polycrystal is deposited on a mask, rather than an etching mode wherein no growth takes place and instead etching goes on and a deposition mode wherein polycrystals are deposited on a mask, is well established. Fig. 7 presents an illustration of how this is achieved in the case of aluminum and indium. Specific values of these quantities differ depending on growth chamber size, temperature, the source materials used, etc., as already noted, but those skilled in the art will be able to determine them optimally, with the equipment used in mind. It is here noted that low temperatures result in an etching rate reduction; in other words, at a low temperature, it is preferable to use the halide gas and/or halogen gas - that are free from the mother elements of the compound to be grown - in an increased amount.

Preferably, the total pressure of the gases fed in is at normal pressure or lower.

Growth temperature is not critical, if it lies within the temperature ranges ordinarily used for general vapor phase growth processes, and may generally lies within the range of about 500 to 800 ° C, preferably about 600 to 800 ° C.

The fabrication process of the invention is effective for the growth of thin semiconductor films of Group III - V compounds , and particularly favorable for the growth of thin semiconductor films of Al-containing Group III - V compounds . More illustratively, the present fabrication process is well suited to the growth of AlInGaP, InAlAs, and AlInP, inter alia, AlGaAs. For the aluminum-containing starting gas, various well-known materials may be used. However, preference is given to using trialkylaluminum, because its reaction is relatively simple in mechanism, it decomposes to produce a gas with a plain behavior, and it is relatively inexpensive. Here, too, preference is given to using HCl as the halide gas and/or halogen gas. Preferably, the amounts of the trialkylaluminum and HCl fed into and used in a growth chamber are such chosen as to permit the molar (HCl/trialkylaluminum) ratio, R, to be 100 or lower. R exceeding 100 is not preferable, because it gives rise to some considerable growth rate reduction and, in some cases, may possibly cause the selective mode to pass into the etching mode. When the thin films of Al-containing Group III - V compounds are doped, it is preferable that the molar ratio R conforms to the following formula :

$$\left.\begin{array}{l} \text{when } 0<X_{Al}\leq 0.2,\ R\leq 100 \\ \text{when } 0.2<X_{Al}\leq 0.4,\ R\leq 50 \\ \text{when } 0.4<X_{Al}\leq 1,\ R\leq 10 \end{array}\right\}\ (I)$$

A departure of R from the range defined by Formulae I - that corresponds to the aluminium molar ratio $X_{Al}$ in the elements of Group III in the compounds of the elements of Groups III-V - is not preferable, because the carriers introduced by doping are likely to be inactivated. Fig. 8 represents the correlation between the molar ratio R and the carrier concentration when triethylaluminum and HCl were respectively used as the trialkylaluminum and the halide gas and/or halogen gas. Fig. 8, plotted on the basis of results of Example 3, teaches that the carrier concentration is largely affected by the molar ratio, $X_{Al}$.

Various well-known types of dopants may be used for the doping of the thin films of Group III - V compounds according to the invention. The dopants, if they are incorporated in the side of Group III, help the present invention produce its own effect greatly, and this is particularly true of silicon and zinc. The effect of the present invention is particularly favorable for fabricating thin semiconductor films of Al-containing Group III - V compounds using silicon and zinc as the dopants.

According to the invention, a trace amount(s) of the halide gas and/or halogen gas - that are free from the mother elements of the compound to be grown - such as HCl is added to the reaction atmosphere during the growth. This enables the compound to be grown under conditions almost similar to those for conventional MOVPE techniques, making it possible to flatten the surface of the crystal film, improve surface morphology or the facets in terms of surface flatness, or effect the growth of high-quality crystals without deposition of polycrystals on a mask over a wide range.

## BRIEF DESCRIPTION OF THE DRAWINGS

Figure 1 is an illustration of the heterostructure used in Example 1,
Figure 2 represents the full width at the half maximum of the PL spectra of the products obtained by the fabrication process of the invention and a conventional process,
Figure 3 represents a SiNx film stripe pattern on the GaAs substrate used in Example 2,
Figure 4 shows one example of the surface photomicrograph after selective growth according to a conventional process,
Figure 5 shows one example of the surface microphotograph. after selective growth according to the process of the invention,
Figure 6 shows another example of the surface microphotograph. structure after selective growth according to the process of the invention,
Figure 7 illustrates the quantity of the halide gas and/or halogen gas used in the invention and the quantity of the halide element-free, feed gases used in the invention,
Figure 8 illustrates the correlation between the molar ratio, R, of hydrogen chloride to triethylaluminium and the carrier concentration, found in Example 3, per molar aluminum ratio, $X_{Al}$, in the Group III elements in the Al-containing. Group III - V compounds.

## BEST MODE FOR CARRYING OUT THE INVENTION

In the following description, the present invention will be explained with reference to some examples. It is understood, however, that the invention is not limited to them insofar as it does not depart from the purport.

### Example 1

The MOVPE technique was used to fabricate a hetero-structure including on a Cr-doped GaAs {100} substrate $Al_{0.3}Ga_{0.7}As$ barrier layers and six GaAs quantum wells having well widths of 10 Å, 20 Å, 30 Å, 60 Å, 80Å and 100 Å, as illustrated in Fig. 1. The then used feed gases were trimethylgallium (TMG), trimethylaluminum (TMA) and arsine ($AsH_3$). The molar flow rates of TMG and TMA were 4.2 x $10^{-5}$ mol/min and 8.4 x $10^{-6}$ mol/min respectively, and the flow rate of 10% $AsH_3$ (diluted with $H_2$) was 800 sccm (standard cubic cm minute). The total flow rate was 7.7 SLM (standard litter minute), the growth temperature 650 °C, the pressure 76 Torr and the growth rate about 1 $\mu$m/h. Under the above growth conditions, 1 cc of HCl was added to the reaction atmosphere during the growth of the $Al_{0.3}Ga_{0.7}As$ barrier layers to prepare Sample (A), and Sample (B) was prepared according to a conventional process making no use of HCl. Under the above growth conditions, the addition of 1 cc of HCl gave rise to a growth rate reduction, but this was barely 2%. These samples were measured at 4.2 K in terms of photoluminescence (PL) to observe light emissions from the quantum wells. The results of Samples (A) and (B) about PL measurement are shown in Fig. 2.

Both Samples (A) and (B) had an almost identical PL strength, but Sample (A) was much smaller in the full width at the half maximum of PL spectra than Sample (B). The full width at the half maximum/of PL spectra has a close relation to the flatness of the heterojunction interface at both ends of the quantum wells; in other words, the flatter the heterojunction interface, the smaller the full width at the half maximum of PL spectra is. From this, it is presumed that the migration of the Al-containing compound is enhanced by the addition of HCl, contributing to making the heterojunction interface much flatter.

### Example 2

A GaAs substrate was provided thereon with a stripe pattern made up of SiNx films arranged at varying widths (3 $\mu$m to 200 $\mu$m) every 100 $\mu$m, as shown in Fig. 3, and an $Al_{0.5}Ga_{0.5}As$ layer or an AlAs layer, each of about 1 $\mu$m in thickness, was grown on the substrate by the MOVPE technique. The then used feed gases were trimethylgallium (TMG), trimethylaluminum (TMA) and arsine ($AsH_3$). The numbers of moles of TMG and TMA fed were 4.8 to 9.6 x $10^{-5}$ mol/min and 1.8 to 3.6 x $10^{-5}$ mol/min respectively, and the flow rate of $AsH_3$ (diluted with 10% $H_2$) was 800 sccm. The total flow rate was 7.7 SLM, the growth temperature 750 °C, the pressure 76 Torr and the growth rate about 2 $\mu$m/h. Under the above growth conditions, 1 cc of HCl was added to the reaction atmosphere during the growth to prepare Sample (C), and Sample (D) was prepared according to a conventional growth process making no use of HCl. Optical micrographs taken of the surfaces of the wafers after the growth are presented in the form of Figs. 4 (Sample (D)) and 5 (Sample (C)). Under the above growth conditions, a growth rate reduction by the addition of 1cc of HCl was 5%. As can be seen from Fig. 4, a thick layer of polycrystal deposits is built up even over the rarrow SiNx film stripe (of 3 mm in width) of Sample (D) having the $Al_{0.5}Ga_{0.5}As$ layer grown thereon. It has been reported about conventional MOVPE techniques that some considerable difficulty is involved in the selective growth of an Al composition having an Al content of 0.35 or more, even when it is carried out at a reduced pressure of a few tens Torr, because the migration length of the Al-containing compound is considerably short. This, too, holds well for Sample (D) prepared by a conventional process.

In the case of Sample (C) prepared by the fabrication process of the invention with the $Al_{0.5}Ga_{0.5}As$ layer formed thereon, on the other hand, no polycrystal deposition is found even over the 200-$\mu$m-wide SiNx film stripe, as can be seen from Fig. 5. In the case of another Sample (C) with the AlAs layer formed thereon, only a few polycrystals are scattered over the 80-$\mu$m-wide SiNx film stripe, as can be seen from Fig. 6. From this, it is presumed that the migration of the Al-containing compound is accelerated by the addition of HCl, enabling its selective growth to be well done.

Example 3

An about 1-$\mu$m-thick $Al_xGa_{1-x}A$ was grown on a (100) GaAs substrate at a varying Al proportion ($X_{Al}$) by MOVPE. The then used supplied gases were trimethylgallium (TMG), trimethylaluminum (TMA) and arsine ($AsH_3$). The molar flow rates of TMG and TMA were 4.8 to 9.6 x $10^{-5}$ mol/min and 1.8 to 3.6 x $10^{-5}$ mol/min respectively, and the flow rate of 10% $AsH_3$ (diluted with $H_2$) was 800 sccm. The dopant used was disilane ($Si_2H_6$), which was added to the reaction atmosphere such that the carrier concentration came under the range of 5.0-10.0 x $10^{17}$ $cm^{-3}$ in the absence of HCl. The total flow rate was 7.7 SLM, the growth temperature 750 °C, the growth pressure 76 Torr and the growth rate about 2 $\mu$m/h. During the growth, the HCl concentration was varied between 1 and 100 in terms of the molar flow rate ratio with respect to TMA. The results are shown in Fig. 8. At an Al composition of 0.1, there is no appreciable carrier concentration decrease, even when the HCl concentration is increased. At an Al proportion exceeding 0.3, however, the carrier concentration starts to decrease from when the molar flow rate ratio of HCl with respect to TMA exceeds 3.

On the other hand, a (100) GaAs substrate provided with a similar SiNx film stripe pattern as shown in Fig. 3 was subjected to the same growth process. In the absence of HCl, polycrystal deposits on the stripes were found, as the Al proportion increased. In the presence of HCl, however, no deposition of polycrystals was found on the stripes.

INDUSTRIAL APPLICABILITY

According to the invention, a trace amount(s) of a halide gas and/or a halogen gas free from the mother elements of the compound to be grown is added to the reaction atmosphere while a compound semiconductor is growing, as detailed above, thereby making it possible to flatten the heterojunction interface, or to effect the growth of high-quality crystals without deposition of polycrystals on the mask used over a wide range. A few % growth rate decrease occurs by the addition of a trace amount of HCl, but the reproducibility and controllability of conventional MOVPE remain almost intact, providing an effective procedure for industrial exploitation.

**Claims**

1. A process for the fabrication of a thin film form of compound semiconductor of elements of Groups III-V using a halogen element-free hydride and a halogen element-free organic metal, characterized in that a halide gas and/or a halogen gas that are free from the mother elements of the compound to be grown are added to the reaction atmosphere at a flow rate that permits the selective mode to be maintained, while the compound is growing.

2. A process according to Claim 1, characterized in that a protective film is used to effect the selective growth of a thin film form of compound semiconductor of elements of Groups III-V, and a halide gas and/or a halogen gas that are free from the mother elements of the compound to be grown are added to the reaction atmosphere, while the compound is growing.

**3.** A process according to Claim 1 or 2, wherein an aluminum-containing organic metal is used to grow the thin film form of compound semiconductor of elements of Groups III-V.

**4.** A process according to Claim 3, wherein the aluminum-containing organic metal is a trialkylaluminum, the growth takes place at a temperature of 500 °C to 800 °C, and the halide gas and/or halogen gas that are free from the mother elements of the compound to be grown are hydrogen chloride gas.

**5.** A process according to Claim 3 or 4, wherein the molar ratio of hydrogen chloride to trialkylaluminum, R, is up to 100.

**6.** A process according to Claim 5, wherein the molar ratio of hydrogen chloride to trialkylaluminum, R, and the molar ratio, $X_{Al}$, of aluminum in the elements of Group III in the aluminum-containing compounds of elements of Groups III-V conform to the following formula:

$$\left.\begin{array}{l} \text{when } 0<X_{Al}\leq 0.2,\ R\leq 100 \\ \text{when } 0.2<X_{Al}\leq 0.4,\ R\leq 50 \\ \text{when } 0.4<X_{Al}\leq 1,\ R\leq 10 \end{array}\right\} \quad (I)$$

**7.** A compound semiconductor producible with the process according to any one of Claims 1-6.

FIG. 1

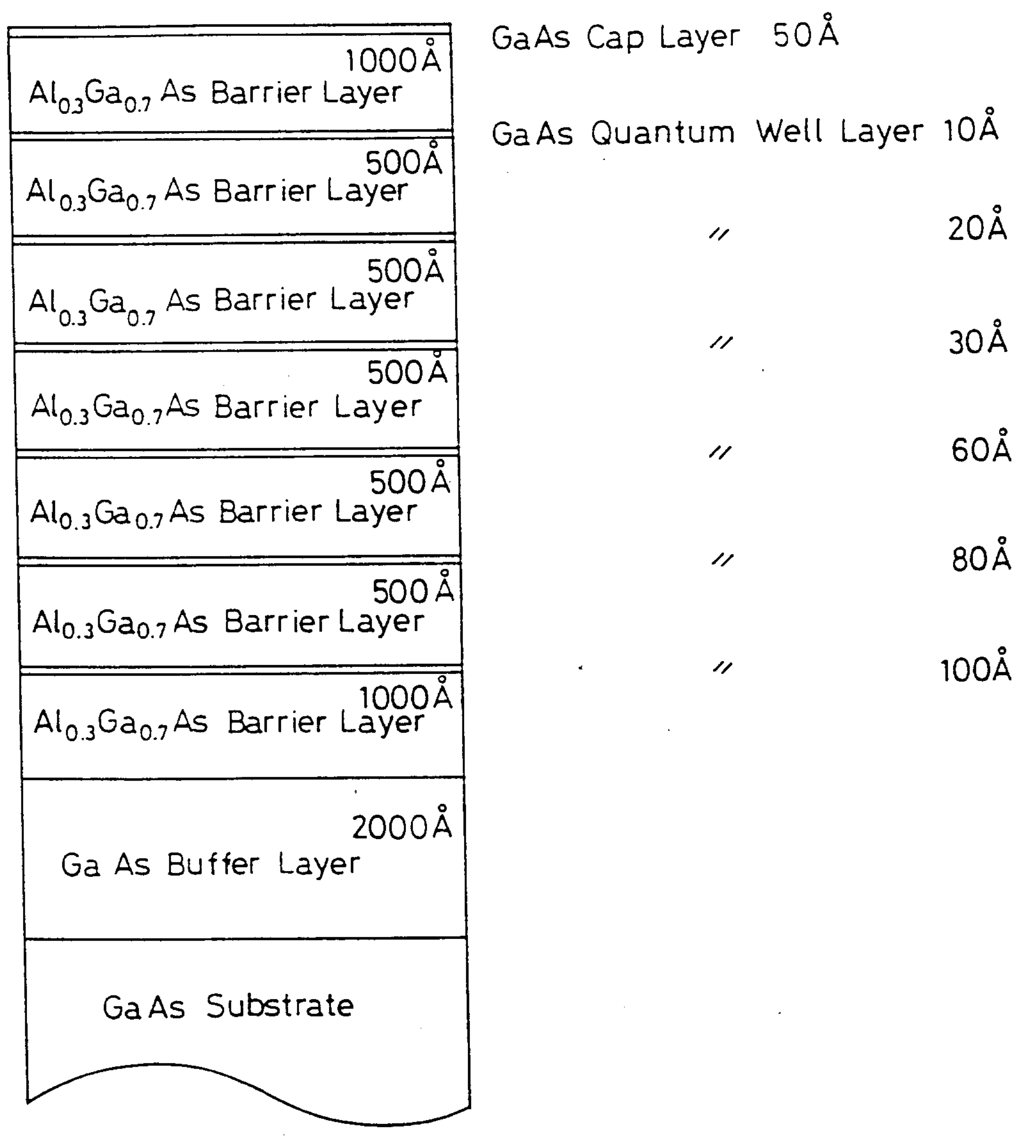
1000Å
$Al_{0.3}Ga_{0.7}As$ Barrier Layer
500Å
$Al_{0.3}Ga_{0.7}As$ Barrier Layer
500Å
$Al_{0.3}Ga_{0.7}As$ Barrier Layer
500Å
$Al_{0.3}Ga_{0.7}As$ Barrier Layer
500Å
$Al_{0.3}Ga_{0.7}As$ Barrier Layer
500Å
$Al_{0.3}Ga_{0.7}As$ Barrier Layer
1000Å
$Al_{0.3}Ga_{0.7}As$ Barrier Layer
2000Å
Ga As Buffer Layer
GaAs Substrate
GaAs Cap Layer 50Å
GaAs Quantum Well Layer 10Å
// 20Å
// 30Å
// 60Å
// 80Å
// 100Å

FIG. 2

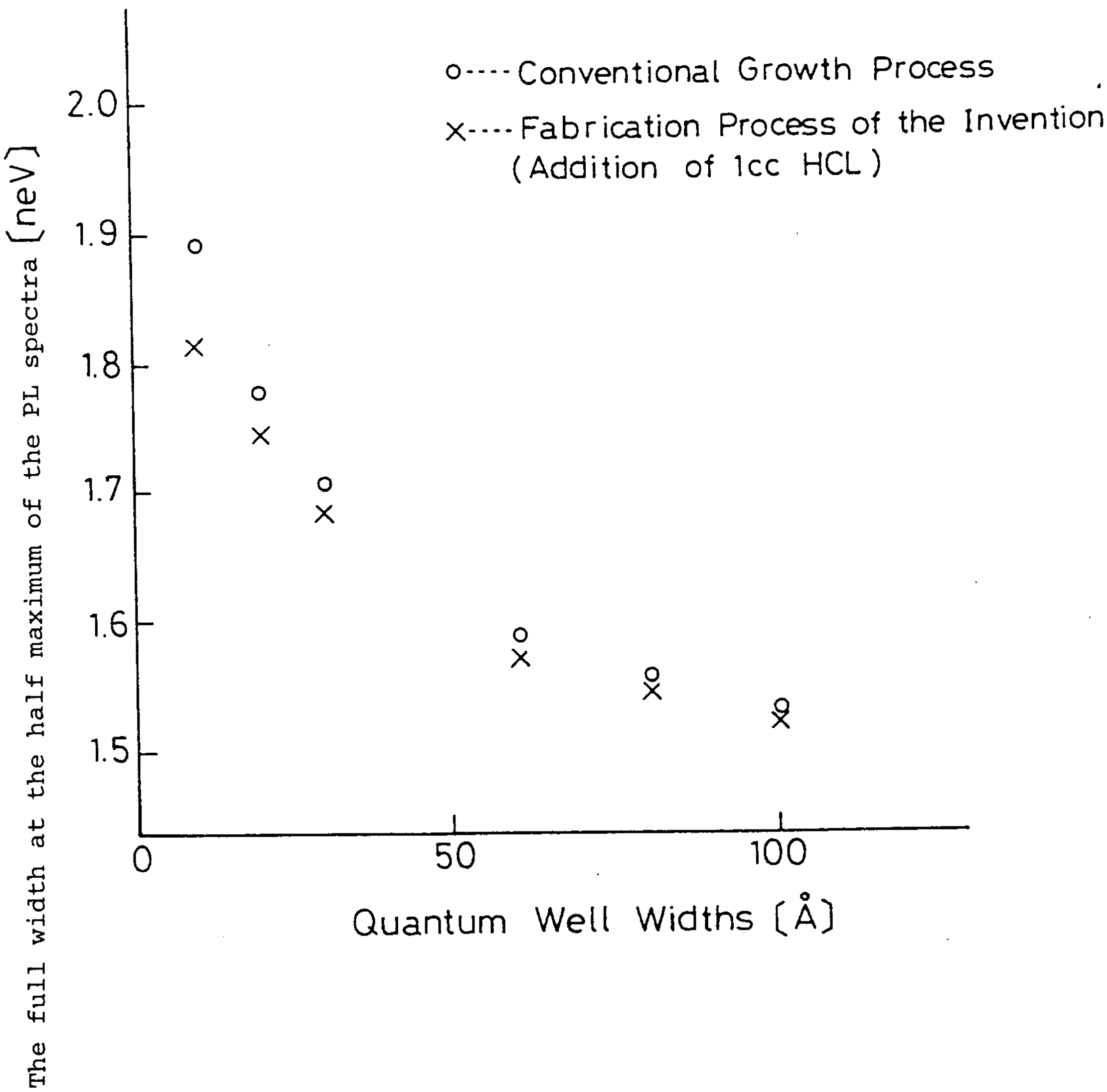
o----Conventional Growth Process
x----Fabrication Process of the Invention
(Addition of 1cc HCL)
2.0
1.9
1.8
1.7
1.6
1.5
0
50
100
Quantum Well Widths [Å]
The full width at the half maximum of the PL spectra [neV]

FIG. 3

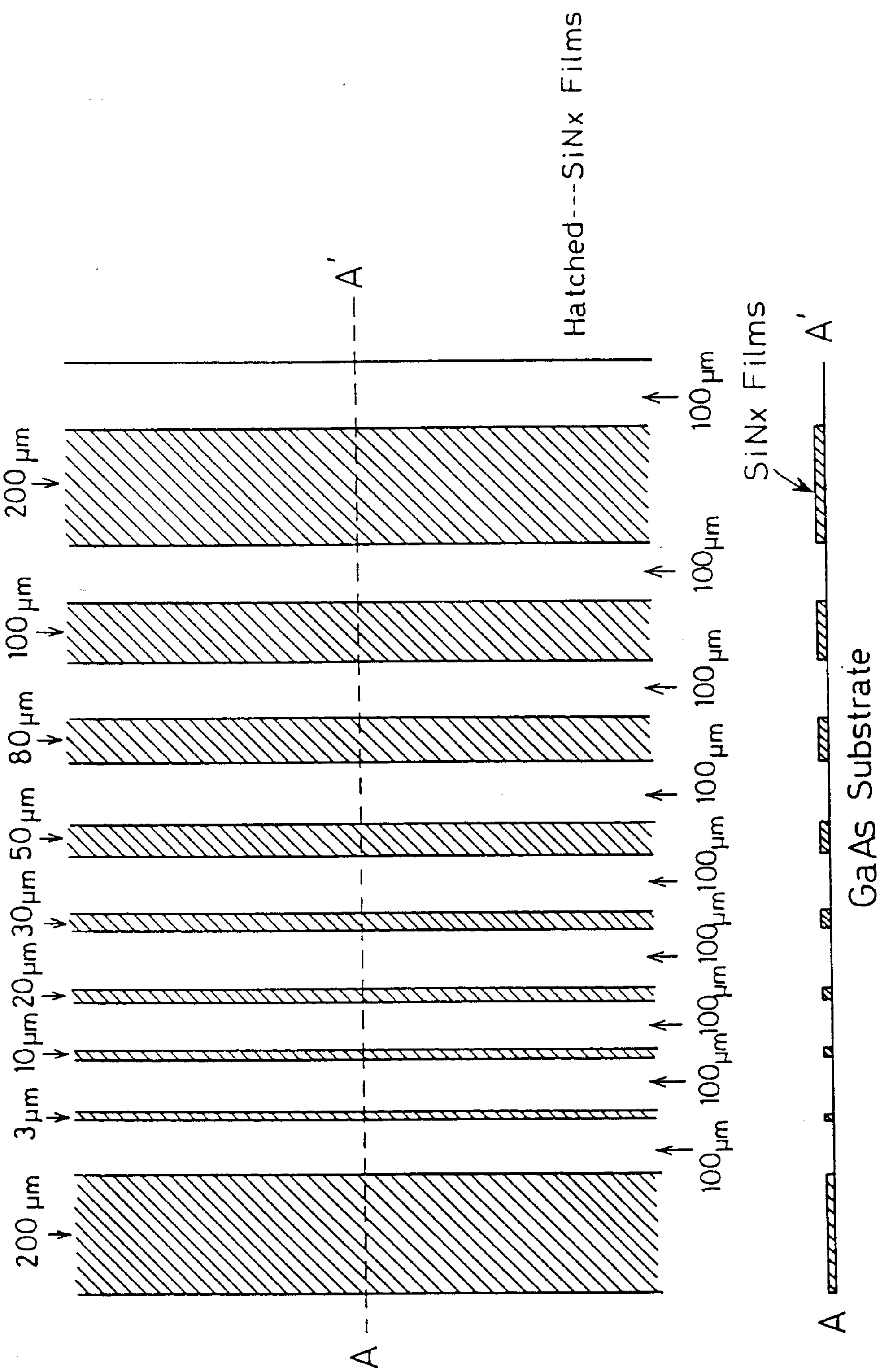
Hatched---SiNx Films
200 µm
3 µm
10 µm
20 µm
30 µm
50 µm
80 µm
100 µm
200 µm
100 µm
A
A'
SiNx Films
GaAs Substrate

FIG. 4

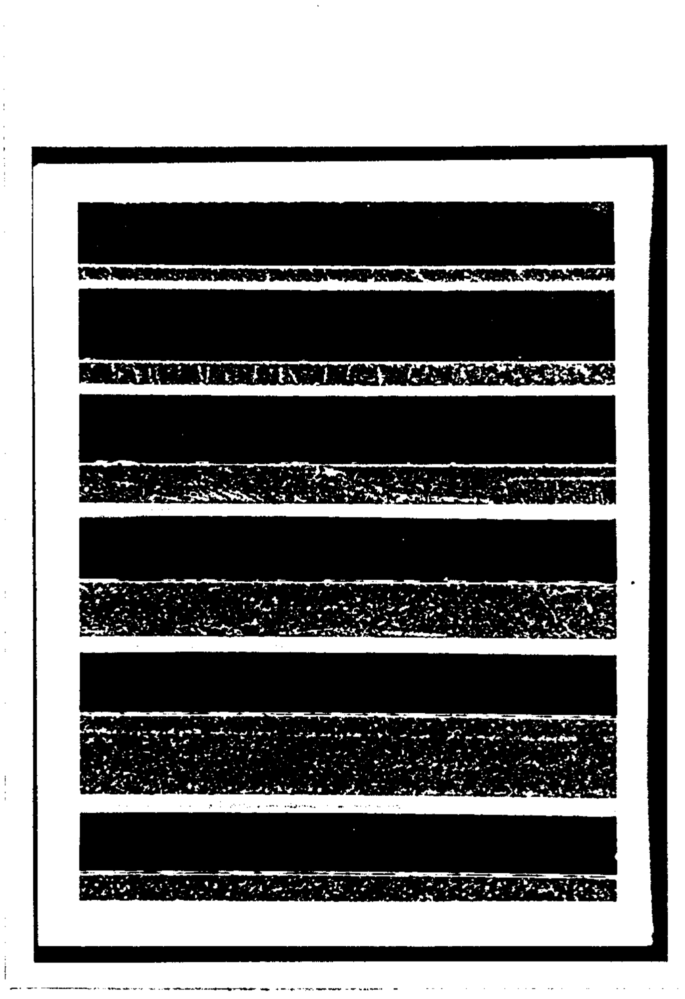

100 μm

FIG. 5

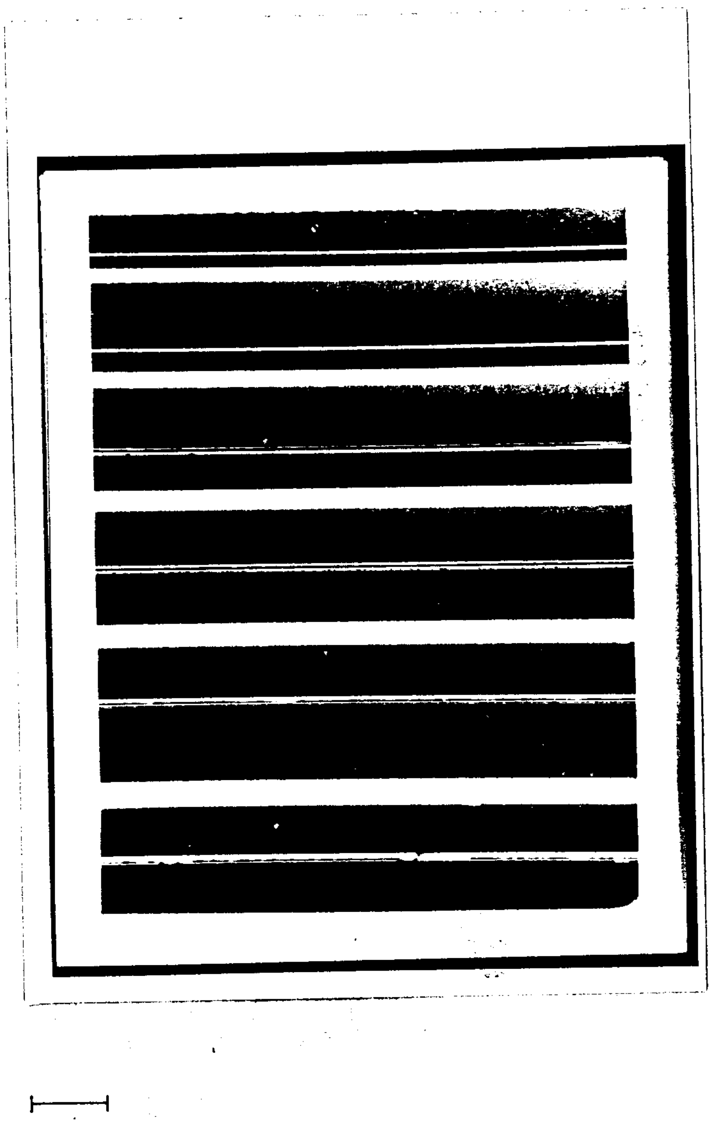

100 µm

FIG. 6

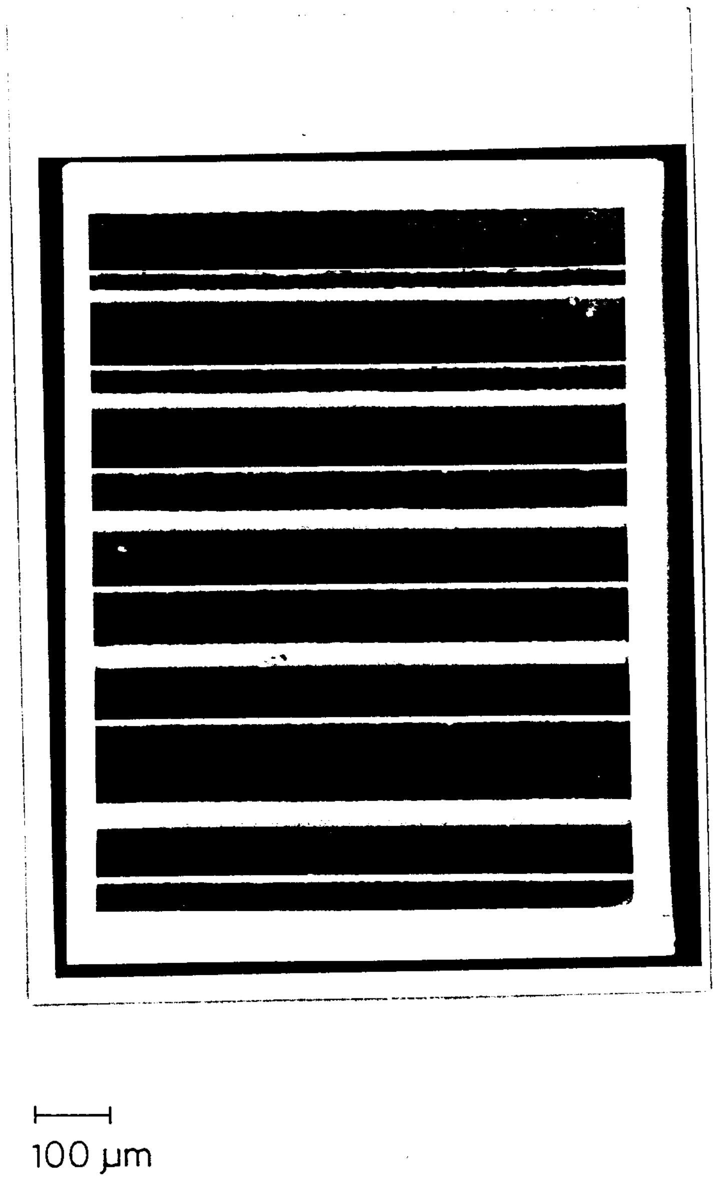

FIG. 7

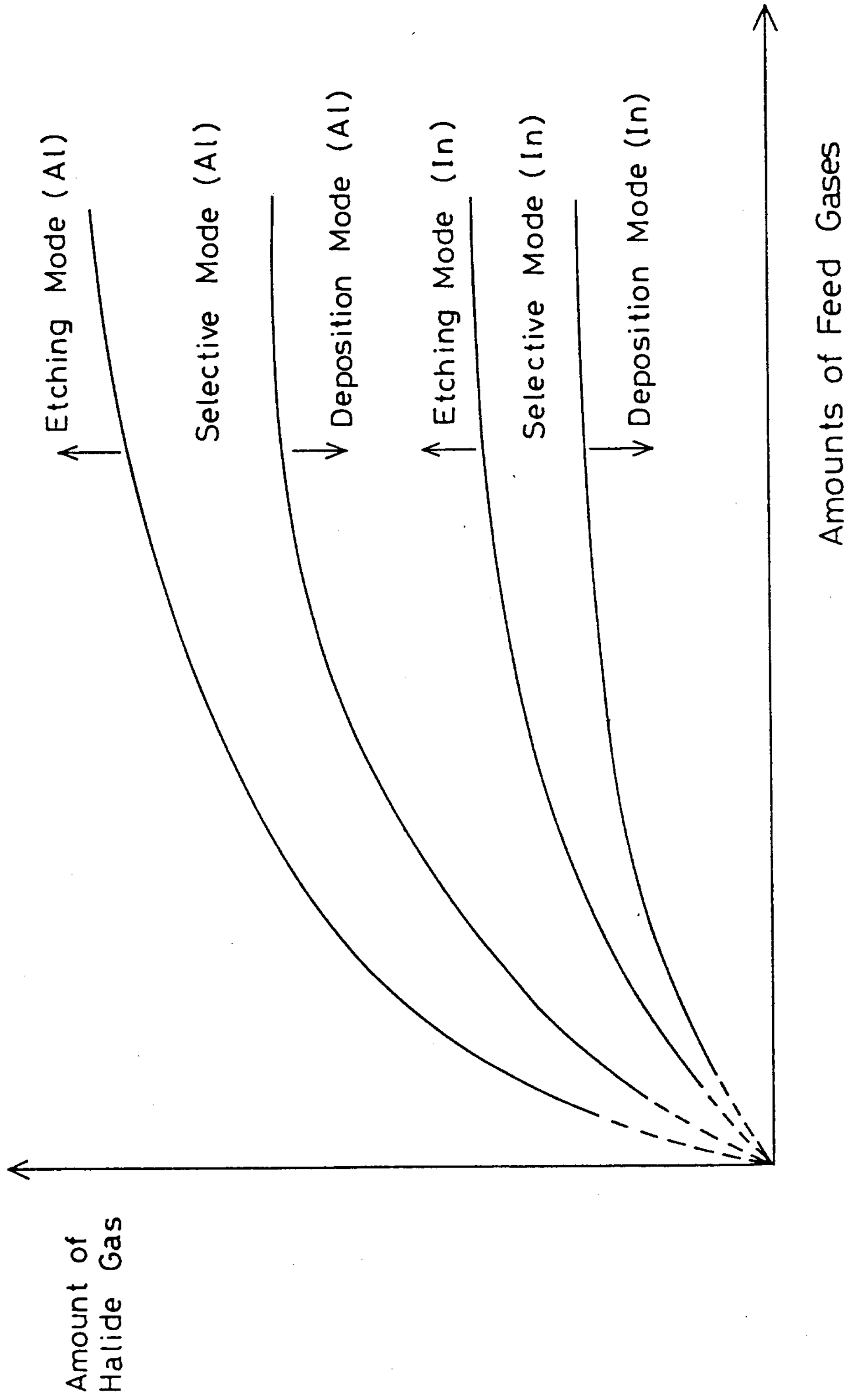
Etching Mode (Al)
Selective Mode (Al)
Deposition Mode (Al)
Etching Mode (In)
Selective Mode (In)
Deposition Mode (In)
Amounts of Feed Gases
Amount of Halide Gas

FIG. 8

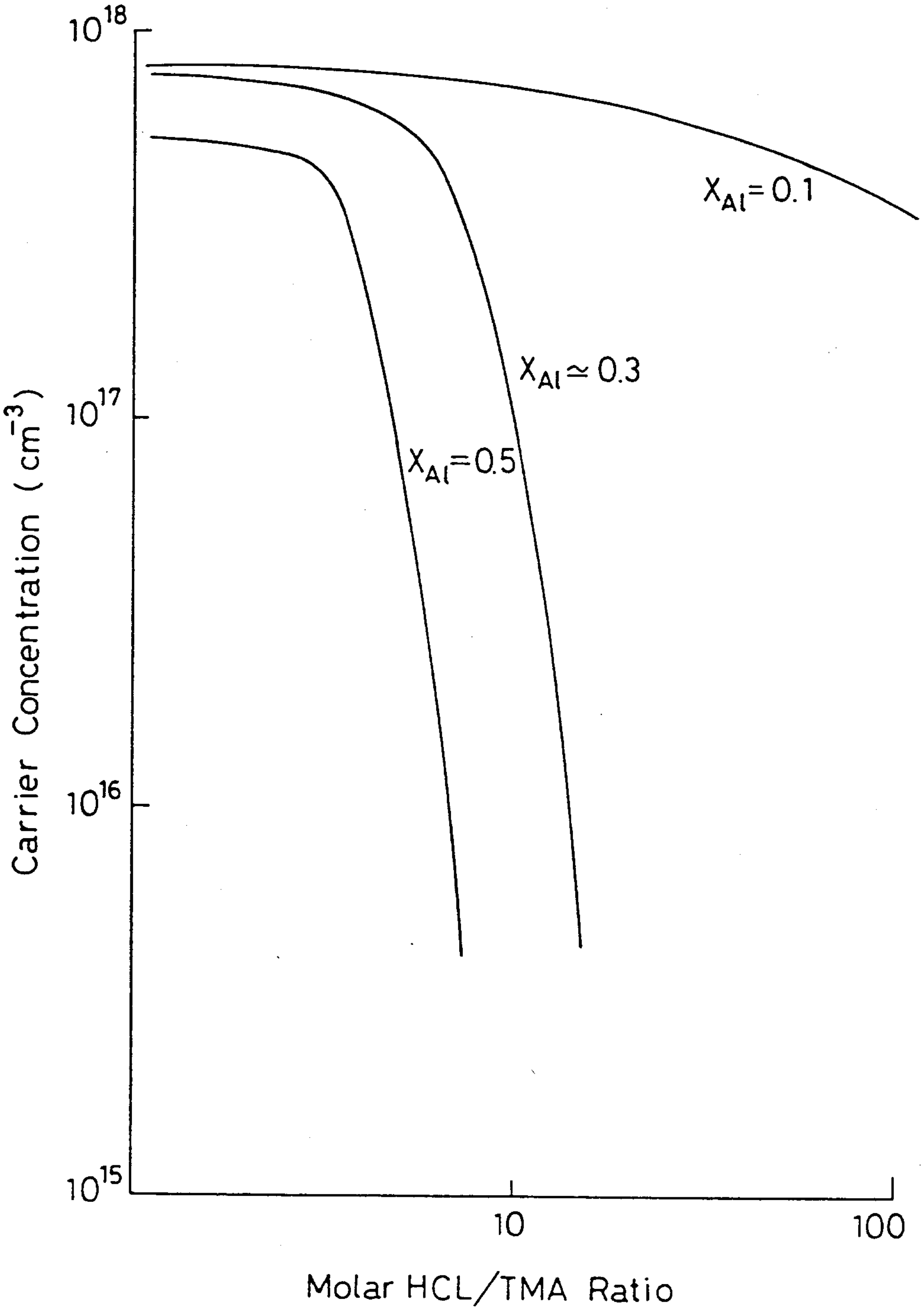
$10^{18}$
$10^{17}$
$10^{16}$
$10^{15}$
Carrier Concentration ( $cm^{-3}$ )
$X_{Al}=0.1$
$X_{Al}\simeq 0.3$
$X_{Al}=0.5$
10
100
Molar HCL/TMA Ratio

# INTERNATIONAL SEARCH REPORT

International Application No PCT/JP92/00850

**I. CLASSIFICATION OF SUBJECT MATTER** (if several classification symbols apply, indicate all) [6]

According to International Patent Classification (IPC) or to both National Classification and IPC

Int. $Cl^5$ H01L21/205

**II. FIELDS SEARCHED**

Minimum Documentation Searched [7]

| Classification System | Classification Symbols |
|---|---|
| IPC | H01L21/20-21/205 |

Documentation Searched other than Minimum Documentation to the Extent that such Documents are Included in the Fields Searched [8]

Jitsuyo Shinan Koho 1971 - 1991

**III. DOCUMENTS CONSIDERED TO BE RELEVANT** [9]

| Category * | Citation of Document, [11] with indication, where appropriate, of the relevant passages [12] | Relevant to Claim No. [13] |
|---|---|---|
| Y | J. Appl. Phys. 50 6 , (1979), pp. 4178-4183 | 1-7 |
| Y | JP, A, 48-32470 (Matsushita Electronics Corp.), April 28, 1973 (28. 04. 73), (Family: none) | 1-7 |
| Y | JP, A, 51-882 (NEC Corp.), January 7, 1976 (07. 01. 76), (Family: none) | 1-7 |

* Special categories of cited documents: [10]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

**IV. CERTIFICATION**

| Date of the Actual Completion of the International Search | Date of Mailing of this International Search Report |
|---|---|
| September 14, 1992 (14. 09. 92) | October 6, 1992 (06. 10. 92) |
| **International Searching Authority** | **Signature of Authorized Officer** |
| Japanese Patent Office | |